# EUROPEAN PATENT APPLICATION

(11) **EP 4 694 661 A1**
(43) Date of publication of application: **11.02.2026**
(21) Application number: 24780580.7
(22) Date of filing: 27.03.2024
(51) Int. Cl.: H10N 60/80, H05K 1/11

(54) **STRUCTURE, QUANTUM PROCESSOR, QUANTUM COMPUTER, AND METHOD FOR MANUFACTURING STRUCTURE**

(30) Priority: 30.03.2023 JP 2023056736; 25.07.2023 JP 2023121107
(71) Applicant: Kyocera Corporation, Kyoto-shi, Kyoto 612-8501 (JP)
(72) Inventor: TANAKA, Takashi, Kyoto-shi, Kyoto 612-8501 (JP)
(74) Representative: TBK
(86) International application number: PCT/JP2024/012524
(87) International publication number: WO 2024/204479

(57) **Abstract**

A structure includes a substrate and a wire. The substrate includes a first surface, a second surface opposite to the first surface, and a through-hole extending from the first surface to the second surface. The wire extends through the through-hole and electrically connects a first conductive portion located on the first surface and a second conductive portion located on the second surface.

## Description

### TECHNICAL FIELD

The present disclosure relates to a structure, a quantum processor, a quantum computer, and a method for manufacturing a structure.

### BACKGROUND OF INVENTION

Semiconductor devices with through-silicon via technology and a method for manufacturing such semiconductor devices are known (refer to, for example, Patent Literature 1 and Non-Patent Literature 1).

### CITATION LIST

### PATENT LITERATURE

Patent Literature 1: WO 2017/141547 Non-Patent Literature 1: Sei-ichi Denda, The State of Development of Through Silicon Via for Three Dimensional Silicon Chip Stacking, [Online] https://www.jstage.jst.go.jp/article/sfj/58/12/58_12_712/_pdf/-char/ja (accessed February 16, 2023)

### SUMMARY

In an aspect of the present disclosure, a structure includes a substrate and a wire. The substrate includes a first surface, a second surface opposite to the first surface, and a through-hole extending from the first surface to the second surface. The wire extends through the through-hole and electrically connects a first conductive portion located on the first surface and a second conductive portion located on the second surface.

In an aspect of the present disclosure, a quantum processor includes the above structure.

In an aspect of the present disclosure, a quantum computer includes the above quantum processor.

In an aspect of the present disclosure, a method for manufacturing a structure includes preparing a substrate precursor and a metal wire, fabricating a substrate by forming a through-hole in the substrate precursor, and threading the metal wire through the through-hole.

### BRIEF DESCRIPTION OF THE DRAWINGS

The objects, features, and advantages of the present disclosure will become more apparent from the following detailed description and the drawings.
FIG. 1 is a plan view of an example structure according to an embodiment of the present disclosure.
FIG. 2 is a cross-sectional view taken along section line II-II in FIG. 1.
FIG. 3 is a cross-sectional view of a substrate illustrating an example shape of a through-hole.
FIG. 4 is a cross-sectional view of the substrate illustrating an example shape of the through-hole.
FIG. 5 is a cross-sectional view of the substrate illustrating an example shape of the through-hole.
FIG. 6 is a cross-sectional view of an example wire extending through the through-hole.
FIG. 7 is a cross-sectional view of an example wire extending through the through-hole.
FIG. 8 is a cross-sectional view of an example quantum processor according to an embodiment of the present disclosure.
FIG. 9 is a plan view of an example superconducting qubit circuit included in the quantum processor in FIG. 8.
FIG. 10 is a perspective view of an example Josephson junction device included in the superconducting qubit circuit in FIG. 9.
FIG. 11 is a block diagram of an example quantum computer according to an embodiment of the present disclosure.
FIG. 12 is a diagram of an example method for manufacturing a structure according to an embodiment of the present disclosure.
FIG. 13 is a diagram of the example method for manufacturing the structure according to the embodiment of the present disclosure.
FIG. 14 is a diagram of the example method for manufacturing the structure according to the embodiment of the present disclosure.
FIG. 15 is a diagram of the example method for manufacturing the structure according to the embodiment of the present disclosure.
FIG. 16 is a diagram of the example method for manufacturing the structure according to the embodiment of the present disclosure.
FIG. 17 is a diagram of the example method for manufacturing the structure according to the embodiment of the present disclosure.
FIG. 18 is a diagram of another example method for manufacturing a structure according to the embodiment of the present disclosure.
FIG. 19 is a diagram of the other example method for manufacturing the structure according to the embodiment of the present disclosure.
FIG. 20 is a diagram of the other example method for manufacturing the structure according to the embodiment of the present disclosure.
FIG. 21 is a diagram of the other example method for manufacturing the structure according to the embodiment of the present disclosure.
FIG. 22 is a diagram of the other example method for manufacturing the structure according to the embodiment of the present disclosure.
FIG. 23 is a plan view of an example structure according to another embodiment of the present disclosure.
FIG. 24 is a cross-sectional view taken along section line XXIV-XXIV in FIG. 23.
FIG. 25 is a cross-sectional view of another example structure according to the other embodiment of the present disclosure.
FIG. 26 is a cross-sectional view of another example structure according to the other embodiment of the present disclosure.

### DESCRIPTION OF EMBODIMENTS

Through-silicon via (TSV) technology refers to three-dimensional integration of electronic components such as a semiconductor device and a printed circuit board. The TSV technology typically involves forming a copper plating layer on an inner peripheral surface of a via formed in a silicon chip and electrically connecting electrodes placed on the front and rear surfaces of the silicon chip through the copper plating layer.

Using copper that is not a superconducting material, the known TSV with a copper plating layer is not applicable to a superconducting device such as a quantum processor. In response to such an issue, one or more aspects of the present disclosure are directed to a technique applicable to a superconducting device and allowing electrodes to be electrically connected through TSV.

In one or more embodiments of the present disclosure, a structure, a quantum processor, a quantum computer, and a method for manufacturing a structure will now be described with reference to the drawings. The drawings used herein are schematic and are not necessarily drawn to scale relative to the actual size of each component. Some of the drawings herein use an orthogonal XYZ coordinate system defined for convenience. An X-axis and a Y-axis represent mutually orthogonal planar directions, and a Z-axis represents a thickness (height) direction. With a positive Z-direction being upward, the terms such as an upper surface, a lower surface, an upper end, and a lower end may be used herein.

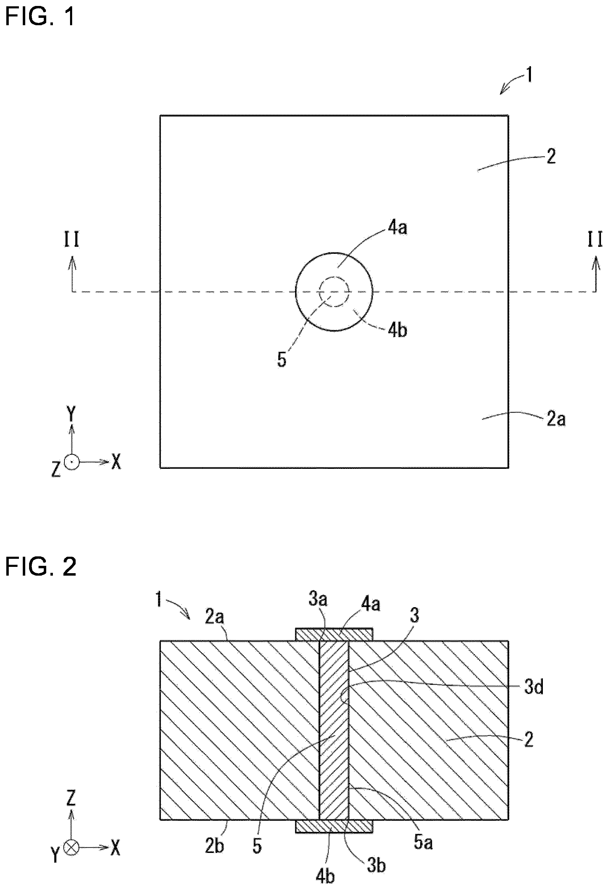

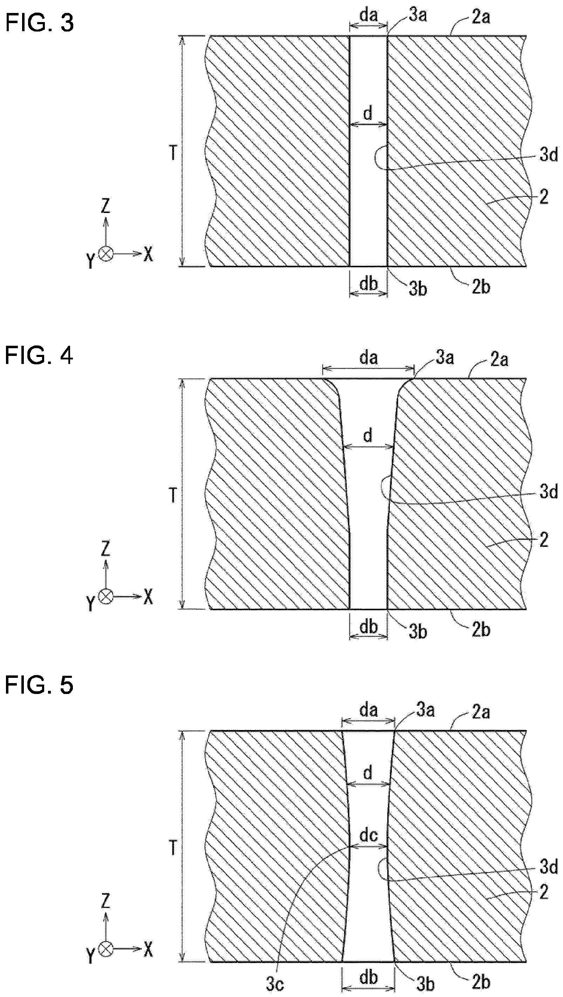

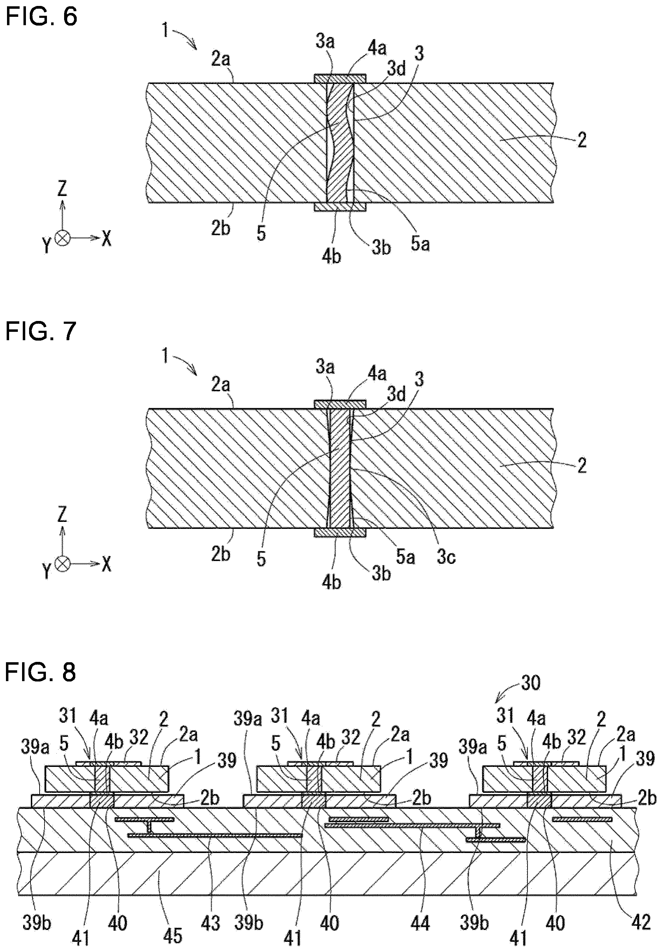

FIG. 1 is a plan view of an example structure according to an embodiment of the present disclosure. FIG. 2 is a cross-sectional view taken along section line II-II in FIG. 1. FIGs. 3 to 5 are cross-sectional views of a substrate each illustrating an example shape of a through-hole. FIGs. 6 and 7 are cross-sectional views of an example wire extending through a through-hole. For ease of illustration, a first conductive portion, a second conductive portion, and a wire are not illustrated in FIGs. 3 to 5.

In the present embodiment, a structure 1 is used for mounting an electric circuit. The electric circuit may be a superconducting circuit such as a superconducting qubit circuit. As illustrated in FIGs. 1 and 2, the structure 1 includes a substrate 2, a first conductive portion 4a, a second conductive portion 4b, and a wire 5. The first conductive portion 4a and the second conductive portion 4b may be referred to as the conductive portions 4a and 4b when not distinguished from each other. Although the structure 1 with a single conductive structure including the conductive portions 4a and 4b and the wire 5 will be described below, the structure 1 may include multiple conductive structures each including the conductive portions 4a and 4b and the wire 5.

As illustrated in FIG. 2, the substrate 2 includes a first surface 2a and a second surface 2b opposite to the first surface 2a. A superconducting circuit such as a superconducting qubit circuit may be mounted on the first surface 2a. The substrate 2 may have, for example, polygonal, circular, elliptical, or other shapes in a plan view. Polygonal shapes include a triangle, a quadrangle, a pentagon, and a hexagon. The substrate 2 may have a thickness of about 100 to 500 µm or a thickness of about 300 µm.

The substrate 2 is made of single-crystal sapphire (Al₂O₃). The material for the substrate 2 is not limited to single-crystal sapphire, but may be single-crystal silicon (Si) or a ceramic material, such as sintered aluminum oxide, sintered mullite, sintered silicon carbide, sintered aluminum nitride, or sintered glass-ceramic.

The substrate 2 includes a through-hole 3 extending from the first surface 2a to the second surface 2b. The through-hole 3 includes a first opening 3a in the first surface 2a and a second opening 3b in the second surface 2b. The first opening 3a and the second opening 3b may be referred to as the openings 3a and 3b when not distinguished from each other.

The first opening 3a and the second opening 3b may have, for example, circular, elliptical, or other shapes in a plan view. In the example described below, the first opening 3a and the second opening 3b are circular in a plan view. The first opening 3a has an opening diameter da, and the second opening 3b has an opening diameter db. The opening diameters da and db may be the same or different from each other. Note that when the first opening 3a and the second opening 3b are noncircular, the opening diameter da of the first opening 3a may be the equivalent circle diameter of the first opening 3a, and the opening diameter db of the second opening 3b may be the equivalent circle diameter of the second opening 3b.

The opening shape of the through-hole 3 in a cross-sectional view parallel to the first surface 2a may be geometrically similar to the shapes of the first opening 3a and the second opening 3b in a plan view. As illustrated in FIG. 3, the through-hole 3 has an opening diameter (also referred to as an inner diameter) d in a cross-sectional view parallel to the first surface 2a, and the opening diameter d may be constant in the thickness direction (Z-direction) of the substrate 2.

The opening diameter d of the through-hole 3 may not be constant in the thickness direction of the substrate 2. As illustrated in FIG. 4, the opening diameter d of the through-hole 3 may gradually increase or decrease. Although the opening diameter d of the through-hole 3 illustrated in FIG. 4 gradually decreases from the first opening 3a toward the second opening 3b, the opening diameter d of the through-hole 3 may gradually increase from the first opening 3a toward the second opening 3b.

As illustrated in FIG. 5, the through-hole 3 may include a narrow part 3c between the first opening 3a and the second opening 3b. The narrow part 3c is a portion at which the opening diameter d of the through-hole 3 is smallest. The narrow part 3c has an opening diameter dc smaller than the opening diameter da and the opening diameter db. With the thickness of the substrate 2 in the thickness direction being T, the narrow part 3c may be located at a depth of about 0.3 to 0.7 T from the first surface 2a or may be located at about 0.5 T. The opening diameter dc of the narrow part 3c may be about 0.5 to 0.9 times the opening diameter da of the first opening 3a and about 0.5 to 0.9 times the opening diameter db of the second opening 3b.

The through-hole 3 may have an aspect ratio of about 3 to 10 or may have an aspect ratio of about 5 to 7. The aspect ratio may be a value obtained by dividing the thickness T of the substrate 2 by the maximum opening diameter d of the through-hole 3.

The first conductive portion 4a is located on the first surface 2a, whereas the second conductive portion 4b is located on the second surface 2b. The conductive portions 4a and 4b may have, for example, circular, elliptical, or other shapes in a plan view. In the example described below, the conductive portions 4a and 4b are circular in a plan view. The conductive portions 4a and 4b may have a thickness of, for example, about 1 to 50 µm, a thickness of about 1 to 10 µm, or a thickness of about 4 to 6 µm.

The conductive portions 4a and 4b may be superconductors. The conductive portions 4a and 4b may be made of a superconducting material, such as aluminum (Al), tantalum (Ta), niobium (Nb), tin (Sn), indium (In), rhenium (Re), palladium (Pd), titanium (Ti), titanium nitride (TiN), niobium nitride (NbN), or niobium-titanium (NbTi).

As illustrated in FIG. 2, the first conductive portion 4a may cover the first opening 3a. In a plan view, the first conductive portion 4a may have a diameter greater than one times and smaller than or equal to about twice the opening diameter da of the first opening 3a. As illustrated in FIG. 2, the second conductive portion 4b may cover the second opening 3b. In a plan view, the second conductive portion 4b may have a diameter greater than one times and smaller than or equal to about twice the opening diameter db of the second opening 3b.

The conductive portions 4a and 4b may be formed using a deposition method, such as physical vapor deposition (PVD), printing, plating, or ALD.

At least one of the first conductive portion 4a or the second conductive portion 4b may be a part of a superconducting circuit mounted on the structure 1. When the superconducting circuit is a superconducting qubit circuit including a Josephson junction device, for example, the first conductive portion 4a may be a part of the Josephson junction device.

As illustrated in FIGs. 2, 6, and 7, the wire 5 extends through the through-hole 3 and connects the first conductive portion 4a and the second conductive portion 4b. When viewed in a cross section perpendicular to the longitudinal direction, the wire 5 may have, for example, circular, elliptical, or other cross-sectional shapes. In the example described below, the wire 5 has a circular cross-sectional shape. When viewed in a cross section perpendicular to the longitudinal direction, the wire 5 may have a diameter φ that is substantially the same as the minimum opening diameter of the through-hole 3 or may have a diameter φ smaller than or equal to the minimum opening diameter of the through-hole 3. For example, the wire 5 may have a diameter φ of about 30 to 70 µm or may have a diameter φ of about 50 µm.

With the first conductive portion 4a covering the first opening 3a and the second conductive portion 4b covering the second opening 3b, the wire 5 may be located in the through-hole 3, with one end connected to the first conductive portion 4a and the other end connected to the second conductive portion 4b. The wire 5 and the conductive portions 4a and 4b may be joined together using, for example, a bonding method that uses at least one of heat or pressure, such as ultrasonic welding or laser welding.

Without the first conductive portion 4a covering the first opening 3a, the end of the wire 5 protruding from the first opening 3a may be connected to the first conductive portion 4a. Without the second conductive portion 4b covering the second opening 3b, the end of the wire 5 protruding from the second opening 3b may be connected to the second conductive portion 4b. The wire 5 and the conductive portions 4a and 4b may be joined together using, for example, a bonding method that uses at least one of heat or pressure, such as ultrasonic welding or laser welding.

The wire 5 may be a superconductor. The wire 5 may be made of a superconducting material, such as aluminum, tantalum, niobium, tin, titanium, indium, rhenium, or palladium.

At least a part of an outer peripheral surface 5a of the wire 5 may be fixed to an inner peripheral surface 3d of the through-hole 3. The part of the outer peripheral surface 5a may be fixed to the inner peripheral surface 3d by thermocompression bonding to the inner peripheral surface 3d.

The wire 5 may be fixed to the inner peripheral surface 3d by friction with at least a part of the outer peripheral surface 5a in contact with the inner peripheral surface 3d of the through-hole 3. As illustrated in FIG. 6, the wire 5 may be bent or curved in the through-hole 3 and fixed to the inner peripheral surface 3d by friction with the bent or curved portion in contact with the inner peripheral surface 3d. As illustrated in FIG. 7, the wire 5 may be fixed to the narrow part 3c by friction with a part of the outer peripheral surface 5a in contact with the narrow part 3c.

The structure 1 can incorporate an electronic circuit, such as an IC chip or an LSI circuit. The structure 1 connects the first conductive portion 4a and the second conductive portion 4b with the wire 5 extending through the through-hole 3. Thus, three-dimensional integration of the structure 1 incorporating an electronic circuit onto a wiring board can achieve a highly integrated electronic device.

Unlike typical TSV, the structure 1 connects the first conductive portion 4a and the second conductive portion 4b without a plating layer formed by, for example, ALD on the inner peripheral surface 3d of the through-hole 3, thus improving mass-manufacturing capability. The structure 1 can also reduce connection failure between the first conductive portion 4a and the second conductive portion 4b caused by defective formation of the plating layer, thus improving the reliability of an electrical device.

The structure 1 including the conductive portions 4a and 4b and the wire 5 that are superconductors can be used in a superconducting device. For example, three-dimensional integration of the structure 1 incorporating a superconducting circuit, such as a qubit circuit, onto a wiring board can achieve a highly integrated quantum processor. This high integration allows the quantum processor to support multiple qubits. With the wire 5 securely connecting the first conductive portion 4a and the second conductive portion 4b, the structure 1 can also improve the reliability of the superconducting device.

The structure 1 includes the substrate 2 made of single-crystal sapphire with a low dielectric loss tangent and thus has low dielectric loss, allowing the qubit circuit to achieve a longer coherence time. This also reduces noise generated in the qubit circuit, thus allowing efficient quantum error correction. The quantum processor can thus operate reliably.

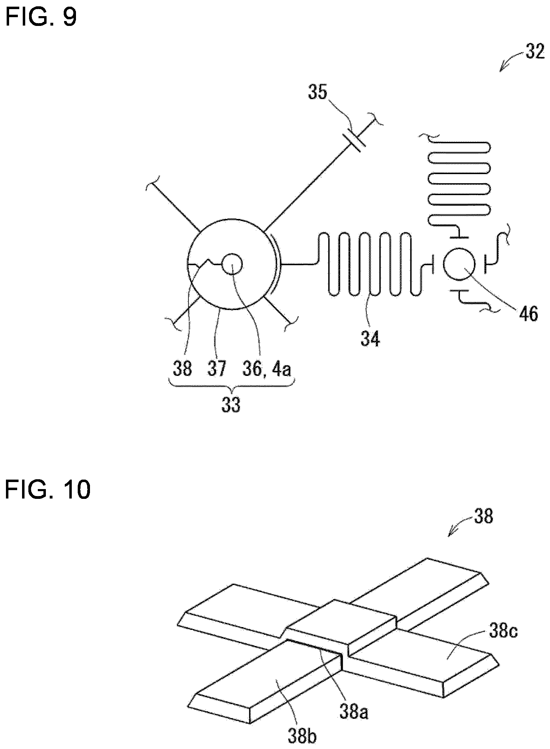

A quantum processor according to one or more embodiments of the present disclosure will now be described. FIG. 8 is a cross-sectional view of an example quantum processor according to an embodiment of the present disclosure. FIG. 9 is a plan view of an example superconducting qubit circuit included in the quantum processor in FIG. 8. FIG. 10 is a perspective view of an example Josephson junction device included in the superconducting qubit circuit in FIG. 9.

In the present embodiment, a quantum processor 30 includes a quantum chip 31, an interposer 39, and a wiring board 42. The quantum chip 31, the interposer 39, and the wiring board 42 may be stacked in this order as illustrated in FIG. 8. As illustrated in FIG. 8, the quantum processor 30 may include a support substrate 45. The quantum chip 31, the interposer 39, and the wiring board 42 are located on the support substrate 45.

As illustrated in FIG. 8, the quantum chip 31 includes the structure 1 and a qubit circuit 32. The qubit circuit 32 is mounted on the structure 1.

As illustrated in FIG. 9, the qubit circuit 32 may include, for example, a qubit 33, a readout resonator 34, an inter-qubit coupling capacitor 35, and a detection electrode 46. The qubit 33, the readout resonator 34, and the inter-qubit coupling capacitor 35 may be mounted on the first surface 2a of the substrate 2.

The qubit 33 may include, for example, a center electrode 36, an annular electrode 37 surrounding the center electrode 36, and a Josephson junction device 38 connecting the center electrode 36 and the annular electrode 37. The center electrode 36 and the annular electrode 37 may be made of a superconducting material, such as aluminum, tantalum, niobium, tin, indium, rhenium, palladium, titanium, titanium nitride, niobium nitride, or niobium-titanium. The center electrode 36 may include the first conductive portion 4a. As illustrated in FIG. 10, the Josephson junction device 38 has, for example, a structure with a dielectric thin film 38a held between superconductors 38b and 38c. The dielectric thin film 38a may be made of insulating oxide, such as aluminum oxide, tantalum oxide, or titanium oxide. The superconductors 38b and 38c may be made of, for example, aluminum, tantalum, or titanium. The qubit 33 can substantially be a two-level system, and maintain, for example, a quantum state (quantum coherence) in a range between a ground state and a first excited state. The qubit 33 is not limited to the concentric qubit illustrated in FIG. 9. The qubit 33 may include, for example, a cross-shaped electrode, an adjacent electrode close to the cross-shaped electrode, and a Josephson junction device connecting the cross-shaped electrode and the adjacent electrode.

The readout resonator 34 is electromagnetically coupled to the qubit 33. The readout resonator 34 is configured to read the quantum state stored in the qubit 33. The state of the qubit 33 read by the readout resonator 34 may be extracted from the qubit circuit 32 through the detection electrode 46 as a detection signal. The detection signal may be extracted from the qubit circuit 32 through the detection electrode 46 and a conductive structure including the conductive portions 4a and 4b and the wire 5. The readout resonator 34 is not limited to the meandered resonator illustrated in FIG. 9. The readout resonator 34 may be, for example, a linear resonator or a U-shaped resonator. The inter-qubit coupling capacitor 35 couples adjacent qubits 33.

The qubit circuit 32 may include a filter resonator (not illustrated) for reducing relaxation of the qubit 33. In this case, the quantum state of the qubit 33 is less likely to be disturbed by, for example, thermal noise or electromagnetic noise, thus allowing the qubit circuit 32 to achieve a longer coherence time.

The quantum chip 31 may include a control circuit (not illustrated) for controlling the qubit 33. The control circuit may be located on the second surface 2b of the substrate 2. The control circuit may be connected to the first conductive portion 4a through the second conductive portion 4b and the wire 5. The control circuit may also be located on the surface of or inside the interposer 39 or may be located on the surface of or inside the wiring board 42.

The interposer 39 may be made of, for example, single-crystal silicon or a ceramic material. The ceramic material used for the interposer 39 may be, for example, sintered aluminum oxide, sintered mullite, sintered silicon carbide, sintered aluminum nitride, or sintered glass-ceramic. The interposer 39 may be made of low-temperature co-fired ceramic (LTCC) and include an internal wiring conductor for controlling the qubit 33 circuit.

The interposer 39 includes a third surface 39a and a fourth surface 39b opposite to the third surface 39a. The interposer 39 is located with the third surface 39a facing the second surface 2b of the substrate 2.

The interposer 39 includes a through-hole 40 extending from the third surface 39a to the fourth surface 39b. The interposer 39 includes a wire 41 located in the through-hole 40. The wire 41 includes an upper end, which may be connected to the second conductive portion 4b in the structure 1. The interposer 39 may include a third conductive portion (not illustrated) covering the upper end opening of the through-hole 40. The upper end of the wire 41 may be connected to the second conductive portion 4b through the third conductive portion. The interposer 39 may include a fourth conductive portion (not illustrated) covering the lower end opening of the through-hole 40. The lower end of the wire 41 may be connected to the fourth conductive portion. The fourth conductive portion may be connected to wiring conductors 43 and 44 in the wiring board 42. The wire 41, the third conductive portion, and the fourth conductive portion may be superconductors. The wire 41 may be made of a superconducting material, such as aluminum, tantalum, niobium, tin, titanium, indium, rhenium, or palladium. The third conductive portion and the fourth conductive portion may be made of a superconducting material, such as aluminum, tantalum, niobium, tin, indium, rhenium, palladium, titanium, titanium nitride, niobium nitride, or niobium-titanium.

The wiring board 42 may be, for example, a printed wiring board, a ceramic wiring board, or an organic wiring board. The wiring board 42 contains the wiring conductors 43 and 44 inside. The wiring conductors 43 and 44 may include a wiring conductor 43 of a superconducting material and a wiring conductor 44 of a normal conducting material. The superconducting material used for the wiring conductor 43 may be, for example, aluminum, tantalum, niobium, tin, indium, rhenium, palladium, titanium, titanium nitride, niobium nitride, or niobium-titanium. The normal conducting material used for the wiring conductor 44 may be, for example, copper (Cu) or silver (Ag).

The support substrate 45 may be made of a metal material, such as copper (Cu) or titanium. The quantum chip 31, the interposer 39, and the wiring board 42 may be placed in a cooling space in a refrigerator with the support substrate 45.

The quantum processor 30 includes the interposer 39 for the quantum chip 31 and the structure 1 facilitating three-dimensional integration on the wiring board 42, thus achieving high integration and multi-qubit design in the quantum processor 30. The quantum processor 30 with the structure 1 including the substrate 2 made of single-crystal sapphire having a low dielectric loss tangent can also extend the coherence time of the qubit circuit 32 and reduce noise generated in the qubit circuit 32. The quantum processor 30 can thus operate reliably.

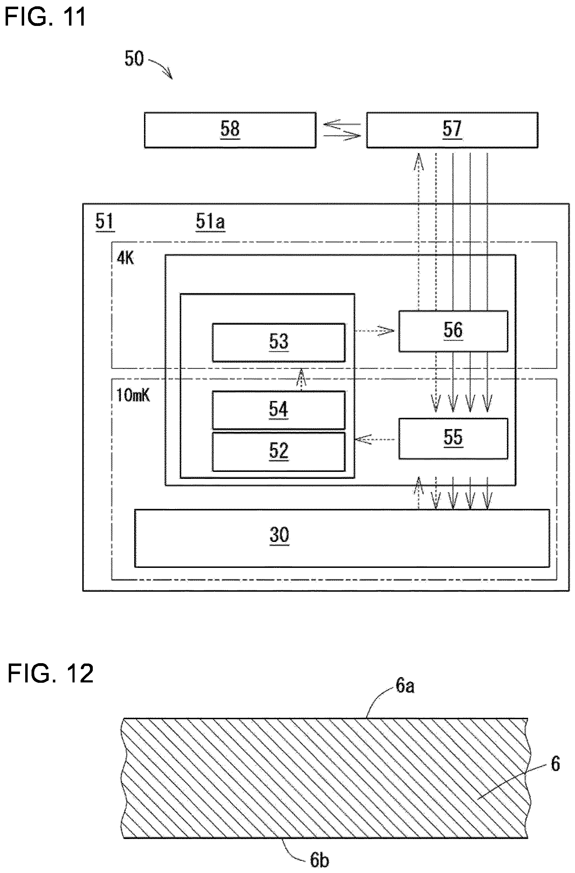

A quantum computer according to one embodiment of the present disclosure will now be described. FIG. 11 is a block diagram of the quantum computer according to the embodiment of the present disclosure.

In the present embodiment, a quantum computer 50 includes the quantum processor 30. The quantum computer 50 may include a refrigerator 51, microwave amplifiers 52 and 53, a circulator 54, a cryogenic noise filter 55, a coaxial cable connector 56, a microwave input-output device 57, and a control computer 58.

The refrigerator 51 includes a cooling space 51a. The quantum processor 30, the microwave amplifiers 52 and 53, the circulator 54, the cryogenic noise filter 55, and the coaxial cable connector 56 are located in the cooling space 51a. The microwave input-output device 57 and the control computer 58 are located outside the cooling space 51a. The refrigerator 51 cools the cooling space 51a to a temperature below (or equal to) the transition temperature of the superconducting material included in the quantum processor 30. The transition temperature is the phase transition temperature between the normal conducting phase and the superconducting phase. The refrigerator 51 may be a dilution refrigerator. The dilution refrigerator uses the heat of dilution of liquid-phase ⁴He with liquid-phase ³He.

The quantum processor 30 may be located in an area within the cooling space 51a with a particularly low temperature (e.g., about 10 mK). This can reduce thermal noise generated in the quantum processor 30 and thus extend the coherence time of the quantum processor 30, allowing the quantum processor 30 to operate reliably. The refrigerator 51 may include a vacuum pump for evacuating the cooling space 51a. The evacuation of the cooling space 51a can reduce temperature variations around the quantum processor 30, allowing the quantum processor 30 to operate reliably.

The control computer 58 generates a control signal for controlling the quantum processor 30. The control signal is provided to the quantum processor 30 through the microwave input-output device 57, the coaxial cable connector 56, and the cryogenic noise filter 55. The quantum processor 30 performs quantum computation based on the control signal provided from the control computer 58. The computation result is output to the control computer 58 through a microwave controller and the microwave input-output device 57.

The quantum computer 50 includes the quantum processor 30 including the structure 1 and thus is highly integrated (or miniaturized). For the cooling space 51a of the refrigerator 51 having a limited volume, the quantum processor 30 can be easily placed in an area within the cooling space 51a with a particularly low temperature. This allows the quantum processor 30 to operate reliably. The quantum computer 50 including the quantum processor 30 including the structure 1 also allows the quantum processor 30 to operate reliably.

An example method for manufacturing the structure according to an embodiment of the present disclosure will now be described. FIGs. 12 to 17 are diagrams of an example method for manufacturing the structure according to the embodiment of the present disclosure.

In this example, the method for manufacturing the structure includes a preparation process, a fabrication process, and a threading process. In this example, the manufacturing method may include a formation process after the threading process. Although the substrate 2 including a single through-hole 3 will now be described, the same or a similar structure applies to a substrate 2 including multiple through-holes 3.

The preparation process includes preparing a substrate precursor 6 (refer to FIG. 12) to be the substrate 2 and a metal wire 7 to be the wire 5.

The substrate precursor 6 includes a first main surface 6a corresponding to the first surface 2a and a second main surface 6b corresponding to the second surface 2b. The substrate precursor 6 may be made of single-crystal sapphire, single-crystal silicon, or a ceramic material. The ceramic material may be, for example, sintered aluminum oxide, sintered mullite, sintered silicon carbide, sintered aluminum nitride, or sintered glass-ceramic. The metal wire 7 may be made of a superconducting material, such as aluminum, tantalum, niobium, tin, titanium, indium, rhenium, or palladium.

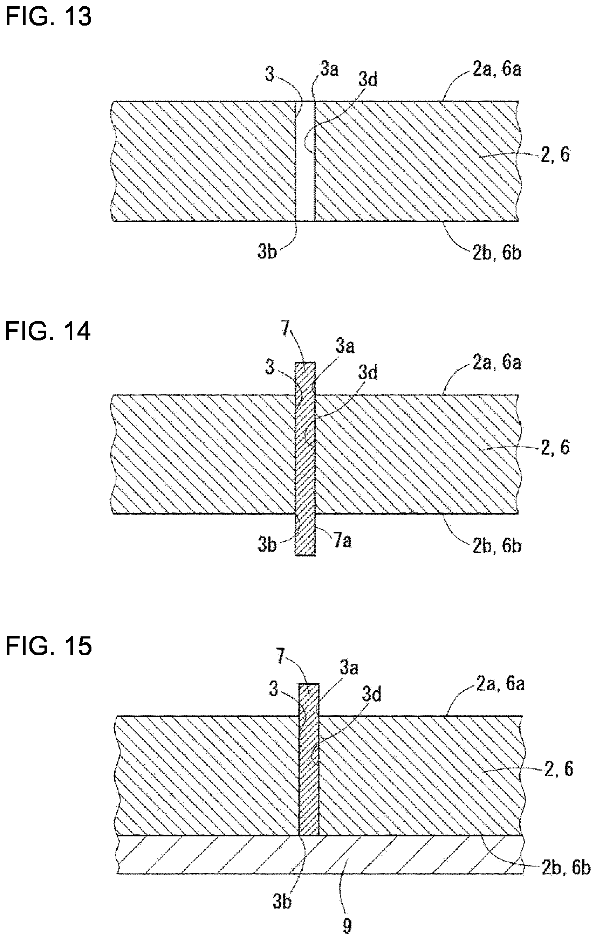

As illustrated in FIG. 13, the fabrication process includes forming a through-hole (hereafter referred to as the through-hole 3) in the substrate precursor 6 to produce the substrate 2. The through-hole 3 extends through the substrate precursor 6 from the first main surface 6a to the second main surface 6b. The through-hole 3 can be formed by laser processing through application of a laser beam to the substrate precursor 6. The laser processing can be performed using, for example, a fiber laser or a YAG laser. The laser beam applied to the substrate precursor 6 may have power of about 1 to 100 W or about 1 to 10 W and may have a frequency of about 1 to 100 kHz.

The laser beam may be applied to the first main surface 6a or the second main surface 6b. For the substrate precursor 6 being thin (e.g., about 300 µm or less), application of a laser beam to the first main surface 6a or the second main surface 6b can form the through-hole 3 with a relatively small difference between an entrance diameter and an exit diameter. The difference between the entrance diameter and the exit diameter may be 10% or less of the thickness of the substrate precursor 6. In this case, the opening diameter d of the through-hole 3 is substantially constant, and the contact area between the inner peripheral surface 3d of the through-hole 3 and the metal wire 7 increases, allowing the metal wire 7 to be fixed firmly to the inner peripheral surface 3d.

When multiple through-holes 3 are formed in the substrate precursor 6, the interval between adjacent through-holes 3 may be greater than or equal to the thickness of the substrate precursor 6. This design facilitates formation of the multiple through-holes 3 while reducing the likelihood of damage on the substrate precursor 6.

The laser beam may be applied to each of the first main surface 6a and the second main surface 6b. In this case, the through-hole 3 can be formed by, for example, applying a laser beam to the first main surface 6a to form a recess in the first main surface 6a with a depth of about half the thickness of the substrate precursor 6, followed by applying a laser beam to the second main surface 6b to form a hole connecting to the recess in the first main surface 6a. For the substrate precursor 6 being thick (e.g., about 300 µm or more), the application of the laser beams to the first main surface 6a and the second main surface 6b can form the through-hole 3 with the opening diameter d remaining nearly constant across the thickness of the substrate 2. This increases the contact area between the inner peripheral surface 3d of the through-hole 3 and the metal wire 7, allowing the metal wire 7 to be fixed firmly to the inner peripheral surface 3d.

When a laser beam is applied to the second main surface 6b, the through-hole 3 including the narrow part 3c (refer to FIG. 5) can be easily formed by stopping the application immediately after the formation of a hole connecting to the recess in the first main surface 6a. Note that immediately after the formation of a hole connecting to the recess in the first main surface 6a refers to the period within a predetermined time after the hole formed on the second main surface 6b connects to the recess in the first main surface 6a. The predetermined time may be determined as appropriate based on, for example, the intended position of the narrow part 3c or the power and frequency of the laser beam.

Although the application of a laser beam to the first main surface 6a is followed by the application of a laser beam to the second main surface 6b in the example described above, the application of a laser beam is not limited to this example. The application of a laser beam to the second main surface 6b may be followed by the application of a laser beam to the first main surface 6a.

The method for forming the through-hole 3 is not limited to laser processing. The through-hole 3 may be formed by etching, such as reactive ion etching (RIE).

As illustrated in FIG. 14, the threading process includes threading the metal wire 7 through the through-hole 3 in the substrate 2. The threading of the metal wire 7 through the through-hole 3 may refer to inserting one end of the metal wire 7 into one opening of the through-hole 3 and causing the end to protrude from the other opening of the through-hole 3 or may also refer to inserting one end of the metal wire 7 into one opening of the through-hole 3 and causing the end to reach the other opening of the through-hole 3. In the threading process, the metal wire 7 may be manually threaded through the through-hole 3 using a camera that can image the opening of the through-hole 3 into which the metal wire 7 is inserted, or the metal wire 7 may be threaded through the through-hole 3 using a wire bonder usable for manufacturing a semiconductor device.

The threading process may include fixing at least a part of an outer peripheral surface 7a of the metal wire 7 to the inner peripheral surface 3d of the through-hole 3. This allows the formation of the substrate 2 with the wire 5 fixed to the inner peripheral surface 3d of the through-hole 3. The threading process may include fixing at least a part of the outer peripheral surface 7a of the metal wire 7 to the inner peripheral surface 3d of the through-hole 3, followed by removing the portions of the metal wire 7 protruding from the openings 3a and 3b.

In the threading process, as illustrated in FIG. 15, the metal wire 7 may be inserted into the through-hole 3 through the first opening 3a with a sacrificial layer 9 placed on the second surface 2b of the substrate 2. In this case, the metal wire 7 does not protrude from the second opening 3b, eliminating the process to remove the portion of the metal wire 7 protruding from the second opening 3b. This can improve the mass-manufacturing capability of the structure 1.

At least a part of the outer peripheral surface 7a may be fixed to the inner peripheral surface 3d by thermocompression bonding the part of the outer peripheral surface 7a to the inner peripheral surface 3d. At least a part of the outer peripheral surface 7a may be thermocompression bonded to the inner peripheral surface 3d by, for example, heating the substrate 2 with the metal wire 7 threaded through the through-hole 3 to a temperature at which the metal wire 7 can undergo plastic deformation. Note that heating of the substrate 2 allows debris resulting from laser processing to be recrystallized and integrated with the substrate 2. This process can reduce the possibility of the debris contaminating the electric circuit (superconducting circuit) incorporated in the structure 1. This can also eliminate the process for cleaning (e.g., etching) to remove debris resulting from laser processing, allowing the structure 1 to be efficiently produced.

The metal wire 7 may not be thermocompression bonded to the inner peripheral surface 3d of the through-hole 3. As illustrated in FIG. 15, with the sacrificial layer 9 placed on the second surface 2b to cover the second opening 3b, the metal wire 7 can be forcefully inserted into the through-hole 3 through the first opening 3a. This insertion can bend or curve the metal wire 7 in the through-hole 3, allowing the metal wire 7 to be in contact with the inner peripheral surface 3d and fixed to the inner peripheral surface 3d by friction as illustrated by the wire 5 in FIG. 6. Note that the sacrificial layer 9 may instead be placed on the first surface 2a. In this case, the metal wire 7 can be forcefully inserted into the through-hole 3 through the second opening 3b, thus being shaped as the wire 5 illustrated in FIG. 6. For the through-hole 3 including the narrow part 3c, a wire 5 having a diameter φ greater than or equal to the opening diameter dc may be threaded through the through-hole 3, allowing the metal wire 7 to be in contact with the narrow part 3c and fixed to the narrow part 3c by friction as illustrated by the wire 5 in FIG. 7.

For the first opening 3a with the opening diameter da larger than the opening diameter db of the second opening 3b, the metal wire 7 can be easily threaded through the through-hole 3 by inserting the metal wire 7 into the through-hole 3 through the first opening 3a. This can improve the mass-manufacturing capability of the structure 1. Note that for the first opening 3a with the opening diameter da smaller than the opening diameter db of the second opening 3b, the metal wire 7 can be easily threaded through the through-hole 3 by inserting the metal wire 7 into the through-hole 3 through the second opening 3b.

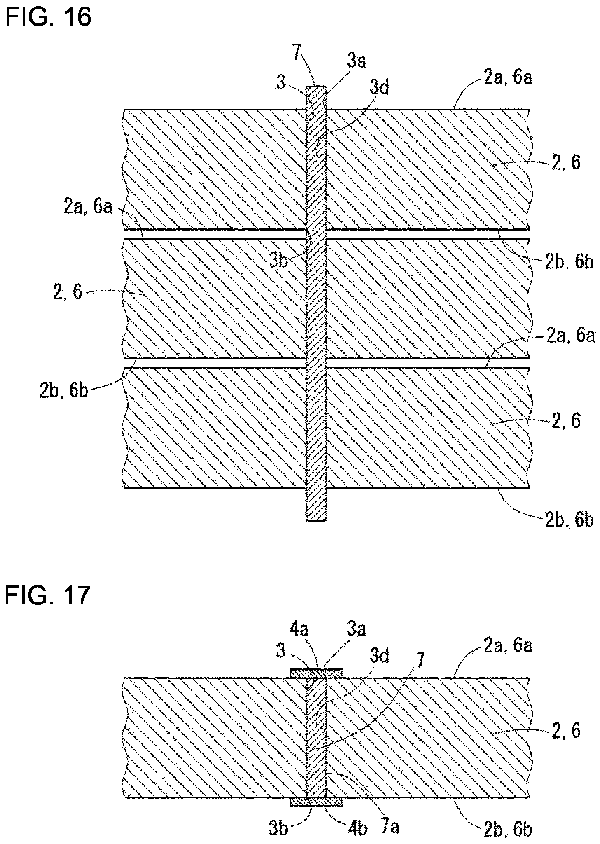

In the threading process, as illustrated in FIG. 16, multiple substrates 2 may be arranged to have the through-holes 3 overlapping in a plan view, and a single metal wire 7 may be threaded through the multiple through-holes 3. In this case, the threading process can be performed efficiently, improving the mass-manufacturing capability of the structure 1. After the metal wire 7 is fixed to the inner peripheral surface 3d of each of the through-holes 3, the portions of the metal wire 7 protruding from the openings 3a and 3b of each of the through-holes 3 can be cut to separate the multiple substrates 2 from each other, each with the metal wire 7 fixed to the inner peripheral surface 3d of the corresponding through-hole 3.

As illustrated in FIG. 17, the formation process includes forming the conductive portions 4a and 4b and connecting the conductive portions 4a and 4b and the metal wire 7. In the formation process, the first conductive portion 4a is formed on the first surface 2a of the substrate 2, whereas the second conductive portion 4b is formed on the second surface 2b of the substrate 2. The first conductive portion 4a may be formed to cover the first opening 3a, whereas the second conductive portion 4b may be formed to cover the second opening 3b.

The conductive portions 4a and 4b may be made of a superconducting material, such as aluminum, tantalum, niobium, tin, indium, rhenium, palladium, titanium, titanium nitride, niobium nitride, or niobium-titanium. The conductive portions 4a and 4b can be formed using a deposition method, such as printing, plating, PVD, or ALD.

The structure 1 can be produced by connecting the first conductive portion 4a and one end of the metal wire 7 and connecting the second conductive portion 4b and the other end of the metal wire 7. The conductive portions 4a and 4b and the metal wire 7 can be joined together using, for example, a bonding method that uses at least one of heat or pressure, such as ultrasonic welding or laser welding.

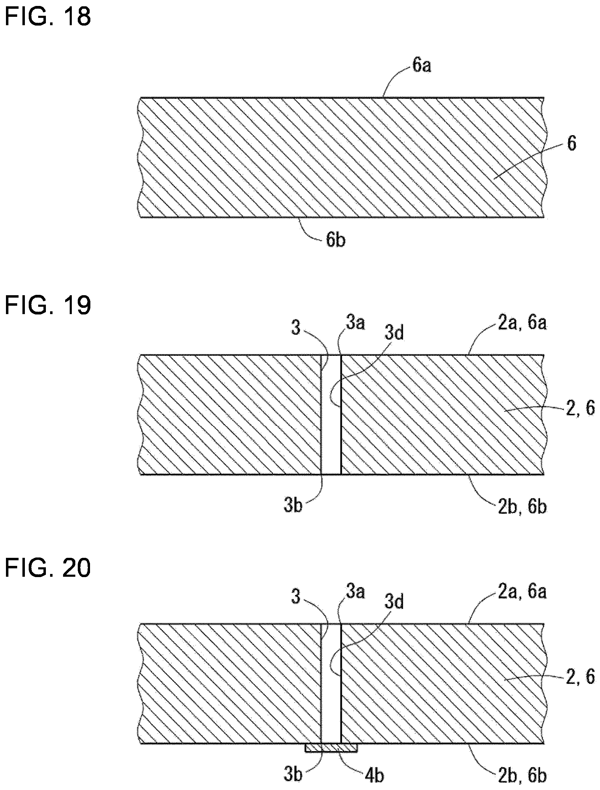

Another example method for manufacturing a structure according to an embodiment of the present disclosure will now be described. FIGs. 18 to 22 are diagrams of another example method for manufacturing the structure according to the embodiment of the present disclosure.

In this example, the method for manufacturing the structure includes a preparation process, a fabrication process, a formation process (also referred to as a first formation process), and a threading process. In this example, the manufacturing method may include a second formation process after the threading process. Although the substrate 2 including a single through-hole 3 will now be described, the same or a similar structure applies to a substrate 2 including multiple through-holes 3. The preparation process and the fabrication process are the same as or similar to the above preparation process and fabrication process and will not be described in detail.

The preparation process includes preparing a substrate precursor 6 (refer to FIG. 18) to be the substrate 2 and a metal wire 8 to be the wire 5. The metal wire 8 has the same or substantially the same length as the thickness T of the substrate 2. The preparation process may include cutting the portion of a metal wire exceeding the thickness T of the substrate 2 to produce the metal wire 8 having the same or substantially the same length as the thickness T.

As illustrated in FIG. 19, the fabrication process includes forming a through-hole (hereafter referred to as the through-hole 3) in the substrate precursor 6 to produce the substrate 2.

As illustrated in FIG. 20, the first formation process includes forming a conductive portion (the first conductive portion 4a or the second conductive portion 4b) on one opening of the through-hole 3 (the first opening 3a or the second opening 3b). In the example described below, the second conductive portion 4b is formed on the second opening 3b of the through-hole 3. However, the first conductive portion 4a may also be formed on the first opening 3a of the through-hole 3. The second conductive portion 4b may cover the second opening 3b. The second conductive portion 4b is formed using a deposition method, such as printing, plating, or PVD. This allows the second conductive portion 4b covering the second opening 3b to be formed without the metal wire 7 in the second opening 3b.

In the first formation process, a conductive portion may be formed on one of the openings 3a and 3b having the smaller opening diameter. This allows a conductive portion to be formed appropriately without the metal wire 8 located in the through-hole 3.

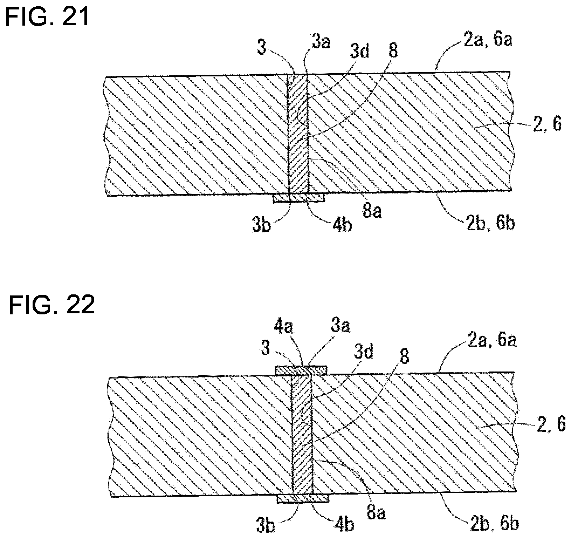

As illustrated in FIG. 21, the threading process includes threading the metal wire 8 through the other opening (the first opening 3a) of the through-hole 3 and connecting the metal wire 8 to the conductive portion (the second conductive portion 4b). To thread the metal wire 8 through the through-hole 3, an electronic component mounting machine for manufacturing a semiconductor device may be used to place the metal wire 8 in the through-hole 3. This allows the metal wire 8 to be rapidly and efficiently placed in the through-hole 3.

In the threading process, the metal wire 8 may be placed in the through-hole 3 through the first opening 3a to connect one end of the metal wire 8 and the second conductive portion 4b. The one end of the metal wire 8 and the second conductive portion 4b can be joined together using, for example, a bonding method that uses at least one of heat or pressure, such as ultrasonic welding or laser welding. In the threading process, at least a part of an outer peripheral surface 8a of the metal wire 8 may or may not be fixed to the inner peripheral surface 3d. At least a part of the outer peripheral surface 8a may be fixed to the inner peripheral surface 3d by thermocompression bonding the part of the outer peripheral surface 8a to the inner peripheral surface 3d.

In the threading process, at least a part of the outer peripheral surface 8a may not be thermocompression bonded to the inner peripheral surface 3d. The metal wire 8 can be forcefully inserted into the through-hole 3 through the first opening 3a. This insertion can bend or curve the metal wire 8 in the through-hole 3, allowing the metal wire 8 to be in contact with the inner peripheral surface 3d and fixed to the inner peripheral surface 3d by friction as illustrated by the wire 5 in FIG. 6. For the through-hole 3 including the narrow part 3c, a metal wire 8 having a diameter φ greater than or equal to the opening diameter dc may be threaded through the through-hole 3, allowing the metal wire 8 to be in contact with the narrow part 3c and fixed to the narrow part 3c by friction as illustrated by the wire 5 in FIG. 7.

For the first opening 3a with the opening diameter da larger than the opening diameter db of the second opening 3b, the metal wire 8 can be easily placed in the through-hole 3 by inserting the metal wire 8 into the through-hole 3 through the first opening 3a. This can improve the mass-manufacturing capability of the structure 1. Note that for the first opening 3a with the opening diameter da smaller than the opening diameter db of the second opening 3b, the metal wire 8 can be easily placed in the through-hole 3 by inserting the metal wire 8 into the through-hole 3 through the second opening 3b.

As illustrated in FIG. 22, the second formation process includes forming a conductive portion (the first conductive portion 4a) on the other opening (the first opening 3a) of the through-hole 3 and connecting the first conductive portion 4a and the metal wire 8 located in the through-hole 3. The first conductive portion 4a may cover the first opening 3a. The first conductive portion 4a can be formed using a deposition method, such as printing, plating, or PVD. The first conductive portion 4a and the metal wire 8 can be joined together using, for example, a bonding method that uses at least one of heat or pressure, such as ultrasonic welding or laser welding.

In the embodiment of the present disclosure, the method for manufacturing the structure allows efficient production of the structure 1.

Although an embodiment of the present disclosure has been described in detail, the present disclosure is not limited to the embodiment described above, and may be changed or varied in various manners without departing from the spirit and scope of the present disclosure. A structure according to another embodiment of the present disclosure will now be described.

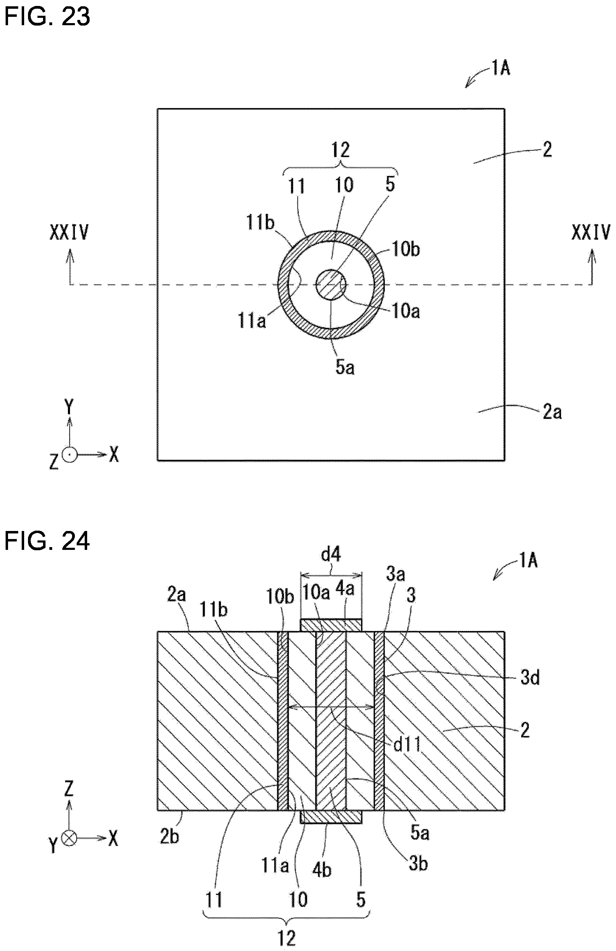

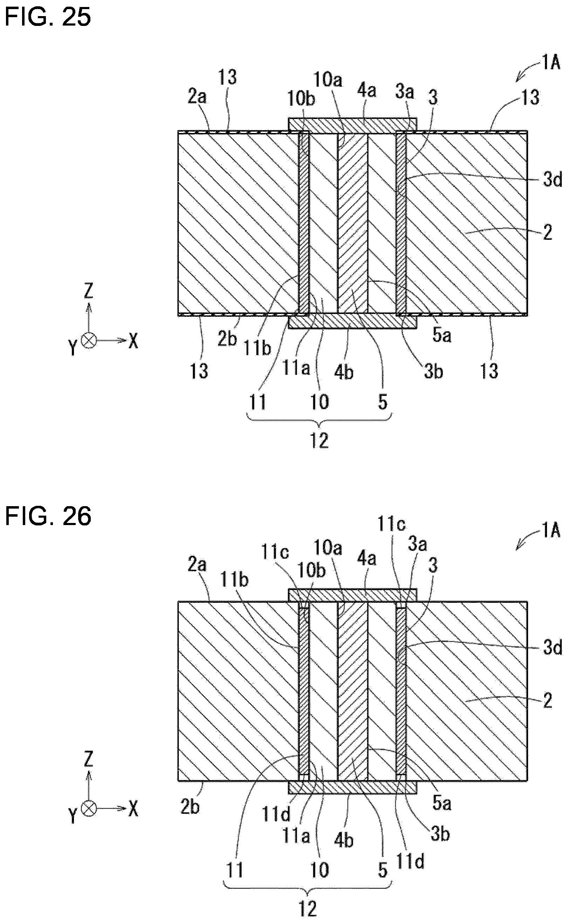

FIG. 23 is a plan view of an example structure according to another embodiment of the present disclosure. FIG. 24 is a cross-sectional view taken along section line XXIV-XXIV in FIG. 23. FIGs. 25 and 26 are cross-sectional views of other example structures according to the other embodiment of the present disclosure. In FIG. 23, a first conductive portion, a second conductive portion, and an insulating layer are not illustrated for ease of illustration, and a wire and an electric conductor are hatched. The cross-sectional views in FIGs. 25 and 26 correspond to the cross-sectional view in FIG. 24. In the present embodiment, the structure differs from the structure according to the above embodiment in including the insulator and the electric conductor. Other components of the structure are the same as or similar to those in the above embodiment. Like reference numerals denote the same components as or similar components to those of the structure according to the above embodiment. Such components will not be described in detail.

In the present embodiment, a structure 1A includes a substrate 2, a first conductive portion 4a, a second conductive portion 4b, a wire 5, an insulator 10, and an electric conductor 11.

As illustrated in FIGs. 23 and 24, the insulator 10 is located in the through-hole 3 in the substrate 2, surrounding the outer peripheral surface 5a of the wire 5. The insulator 10 may fully surround the outer peripheral surface 5a of the wire 5 or partially surround the outer peripheral surface 5a of the wire 5. The insulator 10 may be a hollow column. The insulator 10 includes an inner peripheral surface 10a facing the outer peripheral surface 5a of the wire 5 and an outer peripheral surface 10b opposite to the inner peripheral surface 10a. The insulator 10 may have a thickness of, for example, about 3 to 10 µm (half the difference between the outer diameter and the inner diameter) or a thickness of about 5 µm. The insulator 10 may include, for example, silicon (Si), silica (SiO₂), or alumina (Al₂O₃).

As illustrated in FIGs. 23 and 24, the electric conductor 11 is located in the through-hole 3 in the substrate 2, surrounding the outer peripheral surface 10b of the insulator 10. The electric conductor 11 may fully surround the outer peripheral surface 10b of the insulator 10 or partially surround the outer peripheral surface 10b of the insulator 10. The electric conductor 11 may be a hollow column. The electric conductor 11 includes an inner peripheral surface 11a facing the outer peripheral surface 10b of the insulator 10 and an outer peripheral surface 11b opposite to the inner peripheral surface 11a. At least a part of the outer peripheral surface 11b of the electric conductor 11 may be fixed to the inner peripheral surface 3d of the through-hole 3. The electric conductor 11 may have a thickness of, for example, about 1 to 5 µm (half the difference between the outer diameter and the inner diameter) or a thickness of about 3 µm. The electric conductor 11 may be made of a superconducting material, such as aluminum, tantalum, niobium, tin, titanium, indium, rhenium, or palladium, or a normal conducting material, such as copper or silver. The electric conductor 11 may be made of nonmagnetic ferrite.

The wire 5, the insulator 10, and the electric conductor 11 form a coaxial through electrode 12. The wire 5 is an inner conductor in the coaxial through electrode 12. The electric conductor 11 is an outer conductor in the coaxial through electrode 12. The electric conductor 11 may be connected to a ground potential. The wire 5 and the electric conductor 11 may or may not be concentric.

The conductive portions 4a and 4b are electrically connected to the wire 5 and electrically insulated from the electric conductor 11. In the structure 1A, as illustrated in FIG. 24, the conductive portions 4a and 4b have a diameter d4, and the electric conductor 11 has an inner diameter d11. The diameter d4 may be smaller than or equal to the inner diameter d11. The centroid of the conductive portions 4a and 4b may align or substantially align with the centroid of the wire 5 in a plan view.

The electric conductor 11 can serve as a shielding material that reduces unintended conduction of an electromagnetic wave generated inside or outside the quantum computer 50 into the wire 5 and leakage of an electromagnetic wave from the wire 5. The structure 1A can thus reduce noise generated in the qubit circuit 32 for the quantum processor 30 that is highly integrated. This allows efficient quantum error correction, allowing the quantum processor 30 to operate reliably.

As illustrated in FIG. 25, the structure 1A may include an insulating layer 13. The insulating layer 13 is located between the conductive portions 4a and 4b and the electric conductor 11 to electrically insulate the conductive portions 4a and 4b from the electric conductor 11. The insulating layer 13 may be located between the conductive portions 4a and 4b and the substrate 2 and also between the conductive portions 4a and 4b and the insulator 10 when the insulating layer 13 does not interfere with the electrical connection between the conductive portions 4a and 4b and the wire 5. The insulating layer 13 may be made of, for example, silicon, silica, or alumina. The structure 1A illustrated in FIG. 25 also allows the conductive portions 4a and 4b to be electrically connected to the wire 5 and allows the conductive portions 4a and 4b to be electrically insulated from the electric conductor 11. This can reduce noise generated in the qubit circuit 32 for the quantum processor 30 that is highly integrated. This allows efficient quantum error correction, allowing the quantum processor 30 to operate reliably.

In the structure 1A, as illustrated in FIG. 26, the electric conductor 11 may include an upper end face located downward from an upper end face of the wire 5, and a lower end face located upward from a lower end face of the wire 5. In other words, the coaxial through electrode 12 may include a cutout 11c with a portion of the electric conductor 11 adjacent to the first surface 2a cut away and a cutout 11d with a portion of the electric conductor 11 adjacent to the second surface 2b cut away. The structure 1A illustrated in FIG. 26 also allows the conductive portions 4a and 4b to be electrically connected to the wire 5 and allows the conductive portions 4a and 4b to be electrically insulated from the electric conductor 11. This can reduce noise generated in the qubit circuit 32 for the quantum processor 30 that is highly integrated. This allows efficient quantum error correction, allowing the quantum processor 30 to operate reliably.

An example method for manufacturing the structure 1A will now be described. The structure 1A can be produced by the same manufacturing method as or a similar manufacturing method to the method for manufacturing the structure 1. The same processes as or similar processes to those of the method for manufacturing the structure 1 will be described with reference to the drawings illustrating the method for manufacturing the structure 1 and will not be described in detail below.

In this example, the manufacturing method includes a preparation process, a fabrication process, and a threading process. In this example, the manufacturing method may include a formation process after the threading process.

The preparation process includes preparing a substrate precursor 6 (refer to FIG. 12) and a coaxial cable to be the coaxial through electrode 12. The coaxial cable can be prepared by forming an insulator layer on the outer peripheral surface 7a of the metal wire 7 (refer to FIG. 14) and an electric conductor layer on the outer peripheral surface of the insulator layer opposite to the inner peripheral surface facing the metal wire 7. The insulator layer serves as the insulator 10 in the coaxial through electrode 12. The insulator layer may be made of, for example, silicon, silica, or alumina. The insulator layer can be formed using a thin film deposition method, such as plating or sputtering. The plating may be immersion plating. The electric conductor layer serves as the electric conductor 11 in the coaxial through electrode 12. The electric conductor layer may be made of a superconducting material, such as aluminum, tantalum, niobium, tin, titanium, indium, rhenium, or palladium, or a normal conducting material, such as copper or silver. The conductive material layer may be made of nonmagnetic ferrite. The electric conductor layer can be formed using a thin film deposition method, such as plating or sputtering. The plating may be immersion plating.

The fabrication process includes forming a through-hole 3 in the substrate precursor 6 to produce the substrate 2 (refer to FIG. 13).

The threading process includes threading the coaxial cable through the through-hole 3 in the substrate 2 (refer to FIG. 14). The threading process may include fixing at least a part of the outer peripheral surface of the electric conductor layer to the inner peripheral surface 3d of the through-hole 3. To fix at least a part of the outer peripheral surface of the electric conductor layer to the inner peripheral surface 3d, the part may be thermocompression bonded to the inner peripheral surface 3d or fixed to the inner peripheral surface 3d by friction (refer to FIGs. 6 and 7). The threading process may include fixing at least a part of the coaxial cable to the inner peripheral surface 3d of the through-hole 3, followed by removing the portions of the coaxial cable protruding from the openings 3a and 3b.

In the threading process, the coaxial cable may be manually threaded through the through-hole 3, or the coaxial cable may be threaded through the through-hole 3 using a wire bonder.

In the threading process, the coaxial cable may be inserted into the through-hole 3 through the first opening 3a with a sacrificial layer 9 placed on the second surface 2b of the substrate 2 to cover the second opening 3b (refer to FIG. 15). In this case, the insertion can bend or curve the coaxial cable in the through-hole 3, easily allowing the coaxial cable to be in contact with the inner peripheral surface 3d and fixed to the inner peripheral surface 3d by friction (refer to FIG. 6). In the threading process, multiple substrates 2 may be arranged to have the through-holes 3 overlapping in a plan view, and a single coaxial cable may be threaded through the multiple through-holes 3 (refer to FIG. 16). In this case, the threading process can be efficiently performed, improving the mass-manufacturing capability of the structure 1A.

The formation process includes forming the conductive portions 4a and 4b and connecting the conductive portions 4a and 4b and the metal wire 7 (refer to FIG. 17). In the formation process, the conductive portions 4a and 4b and the metal wire 7 are connected without electrically connecting the conductive portions 4a and 4b and the electric conductor layer. In the formation process, the conductive portions 4a and 4b having a diameter d4 smaller than the inner diameter d11 of the electric conductor 11 (refer to FIG. 24) may be formed to have the centroid aligning or substantially aligning with the centroid of the wire 5 in a plan view. In the formation process, before the conductive portions 4a and 4b are formed, the insulating layer 13 (refer to FIG. 25) may be formed, or cutouts (the cutouts 11c and 11d illustrated in FIG. 26) may be formed in the coaxial cable. The insulating layer 13 can be formed using a thin film deposition method, such as plating or sputtering. The cutouts in the coaxial cable may be formed before the coaxial cable is threaded through the through-hole 3.

The structure 1A can be manufactured with the method described above. With the manufacturing method according to this example, the coaxial through electrode 12 can be fabricated by threading the coaxial cable fabricated separately from the substrate 2 through the through-hole 3. The coaxial cable can be continuously produced by, for example, forming an insulator layer on the outer peripheral surface 7a of the metal wire 7 and forming an electric conductor layer on the outer peripheral surface of the insulator layer while unwinding the metal wire 7 from, for example, a bobbin. With the manufacturing method according to this example, the coaxial through electrode 12 can be fabricated in a shorter time and at lower cost than, for example, the use of deep reactive ion etching (Deep-RIE) or ALD to fabricate a coaxial through electrode in the through-hole 3. This can improve the mass-manufacturing capability of the structure 1A.

Another example method for manufacturing the structure 1A will now be described. In this example, the manufacturing method includes a preparation process, a fabrication process, a formation process (also referred to as a first formation process), and a threading process. In this example, the manufacturing method may include a second formation process after the threading process. The same processes as or similar processes to those of the method for manufacturing the structure 1A will not be described in detail below.

The preparation process includes preparing a substrate precursor 6 and a coaxial cable. The coaxial cable includes a metal wire 8 (refer to FIG. 21), an insulator layer, and an electric conductor layer and has the same or substantially the same length as the thickness T of the substrate 2. The preparation process may include cutting the portion of the coaxial cable exceeding the thickness T of the substrate 2 to produce the coaxial cable having the same or substantially the same length as thickness T. When the structure 1A illustrated in FIG. 26 is produced, the preparation process may include forming cutouts (the cutouts 11c and 11d illustrated in FIG. 26) in the coaxial cable.

The fabrication process includes forming a through-hole 3 in the substrate precursor 6 to produce the substrate 2 (refer to FIG. 13).

The first formation process includes forming the second conductive portion 4b on the second opening 3b of the through-hole 3 to cover the second opening 3b (refer to FIG. 20). Note that when the structure 1A illustrated in FIG. 25 is produced, the first formation process may include forming the insulating layer 13 electrically insulating the second conductive portion 4b from the electric conductor layer in the coaxial cable.

The threading process includes threading the coaxial cable through the first opening 3a of the through-hole 3 and connecting the metal wire 8 of the coaxial cable to the second conductive portion 4b. In the threading process, an electronic component mounting machine may be used to place the coaxial cable in the through-hole 3. This allows the coaxial cable to be rapidly and efficiently placed in the through-hole 3.

The threading process may include fixing at least a part of the outer peripheral surface of the electric conductor layer to the inner peripheral surface 3d of the through-hole 3. To fix at least a part of the outer peripheral surface of the electric conductor layer to the inner peripheral surface 3d, the part may be thermocompression bonded to the inner peripheral surface 3d, or the coaxial cable may be fixed to the inner peripheral surface 3d by friction (refer to FIGs. 6 and 7).

The second formation process includes forming the first conductive portion 4a on the first opening 3a of the through-hole 3 and connecting the first conductive portion 4a and the metal wire 8 (refer to FIG. 17). In the second formation process, the first conductive portion 4a and the metal wire 8 are connected without electrically connecting the first conductive portion 4a and the electric conductor layer. Note that when the structure 1A illustrated in FIG. 25 is produced, the second formation process may include forming the insulating layer 13 electrically insulating the first conductive portion 4a from the electric conductor layer in the coaxial cable.

In this example, the manufacturing method allows the coaxial cable to be rapidly and efficiently placed in the through-hole 3 using an electronic component mounting machine. This can improve the mass-manufacturing capability of the structure 1A.

In one or more embodiments of the present disclosure, TSV-based electrical connection can be easily established between electrodes. The structure according to one or more embodiments of the present disclosure can be used in a superconducting device such as a quantum processor. The structure according to one or more embodiments of the present disclosure easily achieves high integration and multi-qubit design in a quantum processor.

The technique according to one or more embodiments of the present disclosure may have aspects (1) to (12) described below.
(1) A structure, comprising:
   a substrate including a first surface, a second surface opposite to the first surface, and a through-hole extending from the first surface to the second surface; and
   a wire extending through the through-hole and electrically connecting a first conductive portion located on the first surface and a second conductive portion located on the second surface.
(2) The structure according to aspect (1), wherein
   the first conductive portion covers an opening of the through-hole in the first surface, and the second conductive portion covers an opening of the through-hole in the second surface.
(3) The structure according to aspect (1) or aspect (2), wherein
   the wire is a superconductor.
(4) The structure according to any one of aspects (1) to (3), wherein
   the substrate comprises sapphire.
(5) The structure according to any one of aspects (1) to (4), wherein
   the wire is at least partially fixed to an inner peripheral surface of the through-hole.
(6) The structure according to any one of aspects (1) to (4), further comprising:
   an insulator surrounding an outer peripheral surface of the wire; and
   an electric conductor surrounding a surface of the insulator, the surface being opposite to a surface facing the wire.
(7) A quantum processor, comprising:
   the structure according to any one of aspects (1) to (6).
(8) A quantum computer, comprising:
   the quantum processor according to aspect (7).
(9) A method for manufacturing a structure, the method comprising:
   preparing a substrate precursor and a metal wire;
   fabricating a substrate by forming a through-hole in the substrate precursor; and
   threading the metal wire through the through-hole.
(10) The method according to aspect (9), further comprising:
   forming a conductive portion on one opening of the through-hole between the fabricating and the threading.
(11) The method according to aspect (10), wherein
   the threading includes threading the metal wire through another opening of the through-hole and connecting the metal wire to the conductive portion.
(12) The method according to aspect (9), wherein
   the preparing includes forming an insulator layer on an outer peripheral surface of the metal wire and forming an electric conductor layer on a surface of the insulator layer, and the surface is opposite to a surface facing the metal wire, and
   the threading includes threading the metal wire including the insulator layer and the electric conductor layer through the through-hole.

### REFERENCE SIGNS

- 1: structure
- 2: substrate
- 2a: first surface
- 2b: second surface
- 3: through-hole
- 3a: first opening
- 3b: second opening
- 3c: narrow part
- 3d: inner peripheral surface
- 4a: first conductive portion
- 4b: second conductive portion
- 5: wire
- 5a: outer peripheral surface
- 6: substrate precursor
- 6a: first main surface
- 6b: second main surface
- 7, 8: metal wire
- 7a, 8a: outer peripheral surface
- 9: sacrificial layer
- 10: insulator
- 10a: inner peripheral surface
- 10b: outer peripheral surface
- 11: electric conductor
- 11a: inner peripheral surface
- 11b: outer peripheral surface
- 11c, 11d: cutout
- 12: coaxial through electrode
- 13: insulating layer
- 30: quantum processor
- 31: quantum chip
- 32: qubit circuit
- 33: qubit
- 34: readout resonator
- 35: inter-qubit coupling capacitor
- 36: center electrode
- 37: annular electrode
- 38: Josephson junction device
- 38a: dielectric thin film
- 38b, 38c: superconductor
- 39: interposer
- 39a: third surface
- 39b: fourth surface
- 40: through-hole
- 41: wire
- 42: wiring board
- 43: wiring conductor
- 44: wiring conductor
- 45: support substrate
- 46: detection electrode
- 50: quantum computer
- 51: refrigerator
- 51a: cooling space
- 52, 53: microwave amplifier
- 54: circulator
- 55: cryogenic noise filter
- 56: coaxial cable connector
- 57: microwave input-output device
- 58: control computer

## Claims

1. A structure, comprising:
a substrate including a first surface, a second surface opposite to the first surface, and a through-hole extending from the first surface to the second surface; and
a wire extending through the through-hole and electrically connecting a first conductive portion located on the first surface and a second conductive portion located on the second surface.

2. The structure according to claim 1, wherein
the first conductive portion covers an opening of the through-hole in the first surface, and the second conductive portion covers an opening of the through-hole in the second surface.

3. The structure according to claim 1 or claim 2, wherein
the wire is a superconductor.

4. The structure according to any one of claims 1 to 3, wherein
the substrate comprises sapphire.

5. The structure according to any one of claims 1 to 4, wherein
the wire is at least partially fixed to an inner peripheral surface of the through-hole.

6. The structure according to any one of claims 1 to 5, further comprising:
an insulator surrounding an outer peripheral surface of the wire; and
an electric conductor surrounding a surface of the insulator, the surface being opposite to a surface facing the wire.

7. A quantum processor, comprising:
the structure according to any one of claims 1 to 6.

8. A quantum computer, comprising:
the quantum processor according to claim 7.

9. A method for manufacturing a structure, the method comprising:
preparing a substrate precursor and a metal wire;
fabricating a substrate by forming a through-hole in the substrate precursor; and
threading the metal wire through the through-hole.

10. The method according to claim 9, further comprising:
forming a conductive portion on one opening of the through-hole between the fabricating and the threading.

11. The method according to claim 10, wherein
the threading includes threading the metal wire through another opening of the through-hole and connecting the metal wire to the conductive portion.

12. The method according to claim 9, wherein
the preparing includes forming an insulator layer on an outer peripheral surface of the metal wire and forming an electric conductor layer on a surface of the insulator layer, and the surface is opposite to a surface facing the metal wire, and
the threading includes threading the metal wire including the insulator layer and the electric conductor layer through the through-hole.
